# EUROPEAN PATENT APPLICATION

(11) **EP 4 811 607 A1**
(43) Date of publication of application: **23.09.2026**
(21) Application number: 24915783.5
(22) Date of filing: 27.08.2024
(51) Int. Cl.: H02J 50/80, H02J 50/12, H04B 5/26, H04B 5/79, H02J 50/90, H02J 50/60, G01R 19/165, H04B 5/24, H02J 7/00, H02J 7/02

(54) **ELECTRONIC DEVICE FOR WIRELESSLY CHARGING BATTERY**

(30) Priority: 02.01.2024 KR 20240000255; 27.03.2024 KR 20240041476
(71) Applicant: Samsung Electronics Co., Ltd., Suwon-si, Gyeonggi-do 16677 (KR)
(72) Inventor: SHIN, Seungshik, Suwon-si, Gyeonggi-do 16677 (KR); CHOI, Jinsik, Suwon-si, Gyeonggi-do 16677 (KR); PARK, Baewon, Suwon-si, Gyeonggi-do 16677 (KR); PARK, Sungchul, Suwon-si, Gyeonggi-do 16677 (KR); YE, Sangmin, Suwon-si, Gyeonggi-do 16677 (KR); CHO, Woosik, Suwon-si, Gyeonggi-do 16677 (KR)
(74) Representative: Gulde & Partner
(86) International application number: PCT/KR2024/012773
(87) International publication number: WO 2025/146894

(57) **Abstract**

This electronic device includes: a battery; a coil; a wireless charging circuit configured to rectify power received from a power supply device through the coil and provide the rectified power to charge the battery; and a processor configured to output a signal related to a charging mode of the wireless charging circuit. The wireless charging circuit performs configuration operations of a first charging mode for receiving first power from the power supply device. The wireless charging circuit operates in the first charging mode for receiving the first power when the configuration operations of the first charging mode are completed. The wireless charging circuit initiates wireless charging when the configuration operations of the first charging mode fails, performs configuration operations of a second charging mode for receiving second power lower than the first power from the power supply device on the basis of a signal received from the processor, and operates in the second charging mode for receiving the second power.

## Description

### [Technical Field]

An embodiment of the present disclosure relates to an electronic device for wirelessly charging a battery.

### [Background Art]

A wireless power consortium (WPC) is an organization established for the purpose of formulation and dissemination of a standard Qi of wireless charging. According to the Qi standard, a baseline power profile (BPP) supports wireless charging of 5W or less, and an extended power profile (EPP) supports high-speed wireless charging of 15W or less.

According to the BPP, an operation for wirelessly charging a battery of a power receiving device between the power receiving device (e.g., a smart phone) and a power supply device (e.g., a wireless charging pad) may include a signal strength (SS) identification (ID) stage, a configuration stage, and a power transfer stage. In the SS ID stage, the power supply device may identify the power receiving device on the basis of a response of the power receiving device to a ping signal (or, a wakeup signal) transmitted by the power supply device. In the configuration stage, the power supply device may configure a power value to be transmitted to the power receiving device through data communication with the power receiving device. In the power transfer stage, the power supply device may transmit power having the configured power value to the power receiving device through a coil.

According to the EPP, a wireless charging operation may further include a negotiation stage and a calibration stage performed after the configuration stage. After the calibration stage is completed, the power transfer stage may be performed. In the negotiation stage, the power supply device may check a quality of electrical coupling between a transmission coil and a reception coil and may negotiate a maximum power capable of being supplied to the power receiving device with the power receiving device. In the calibration stage, the power supply device measures power loss (e.g., friendly metal loss), and on the basis of the measured power loss, the power supply device calibrates a value of power to be supplied to the power receiving device, whereby accuracy of foreign substance detection (e.g., foreign object detection (FOD)) may be increased.

The information described above is provided as the related art for the purpose of enhancing the understanding of the present disclosure. No assertion or determination is made with respect to the applicability of any of the above-mentioned as the prior art related to the present disclosure.

### [Disclosure of Invention]

### [Technical Problem]

The power receiving device is awakened by a power signal (e.g., digital ping) received from the power supply device and may initiate wireless charging for the battery in an EPP mode. Even if two devices are close to each other, when the transmission coil and the reception coil are not aligned side by side, an electrical connection between the two devices is disconnected, and wireless charging may be restarted from the beginning (e.g., the SS ID stage).

When a misalignment state between the coils persists, the battery is not actually charged, and disconnection and reconnection between the two devices may be repeated. From a user's standpoint, it may be mistaken as being under charging.

An embodiment of the present disclosure may provide the electronic device (the power receiving device) configured to stably charge the battery without disconnection after battery charging is initiated. Technical problems to be solved by the present disclosure are not limited to the above-mentioned technical problems, and other technical problems, which are not mentioned above, may be clearly understood from the following descriptions by those skilled in the art to which the present invention pertains.

### [Solution to Problem]

According to an embodiment, an electronic device may comprise: a battery; a coil; a wireless charging circuit configured to rectify power received from a power supply device through the coil and provide the rectified power to charge the battery; and a processor configured to output a signal related to a charging mode of the wireless charging circuit. The wireless charging circuit may be configured to perform configuration operations of a first charging mode for receiving first power from the power supply device. The wireless charging circuit may be configured to operate in the first charging mode for receiving the first power when the configuration operations of the first charging mode are completed. The wireless charging circuit may be configured to, when the configuration operations of the first charging mode fail, initiate wireless charging, and perform configuration operations of a second charging mode for receiving second power lower than the first power from the power supply device on the basis of a signal received from the processor, and operate in the second charging mode for receiving the second power.

According to an embodiment, a method for operating an electronic device may comprise performing, by a wireless charging circuit of the electronic device, configuration operations of a first charging mode for receiving first power from a power supply device through a coil of the electronic device. The method may comprise operating, by the wireless charging circuit, in the first charging mode for receiving the first power when the configuration operations of the first charging mode are completed. The method may comprise, when the configuration operations of the first charging mode fail, initiating wireless charging by the wireless charging circuit, performing configuration operations of a second charging mode for receiving second power lower than the first power from the power supply device on the basis of a signal output from a processor of the electronic device to the wireless charging circuit, and operating in the second charging mode for receiving the second power.

According to an embodiment, a non-transitory recording medium may store instructions readable by an electronic device. The instructions, when executed, may cause the electronic device to perform an operation of performing, by a wireless charging circuit of the electronic device, configuration operations of a first charging mode for receiving first power from a power supply device through a coil of the electronic device The instructions, when executed, may cause the electronic device to perform an operation of operating, by the wireless charging circuit, in the first charging mode for receiving the first power when the configuration operations of the first charging mode are completed. The instructions, when executed, may cause the electronic device to perform an operation of, when the configuration operations of the first charging mode fail, initiating wireless charging by the wireless charging circuit, performing configuration operations of a second charging mode for receiving second power lower than the first power from the power supply device on the basis of a signal output from a processor of the electronic device to the wireless charging circuit, and operating in the second charging mode for receiving the second power.

### [Advantageous Effects of Invention]

According to an embodiment of the present disclosure, an electronic device may stably charge a battery without disconnection after battery charging is initiated. In addition, various effects that may be directly or indirectly identified through the present document may be provided.

### [Brief Description of Drawings]

FIG. 1 is a block diagram of an electronic device in a network environment, according to various embodiments.
FIG. 2A illustrates a wireless charging system, according to an embodiment. FIG. 2B illustrates a charging profile capable of being implemented in the wireless charging system of FIG. 2A.
FIG. 3 is a view for explaining operations for wireless charging in a power receiving device when a transmission coil and a reception coil are in an aligned state, according to an embodiment.
FIG. 4 is a view for explaining operations for wireless charging in a power receiving device when a transmission coil and a reception coil are not in an aligned state, according to an embodiment.
FIG. 5 is a view for explaining operations for wireless charging in a power receiving device when a transmission coil and a reception coil are aligned again after separation according to a user's intention, according to an embodiment.
FIG. 6 is a view for explaining operations for wireless charging in a power receiving device when a transmission coil and a reception coil are in an aligned state, according to an embodiment.
FIG. 7 is a flowchart for explaining operations for charging a battery in a power receiving device, according to an embodiment.
FIG. 8 is a flowchart for explaining operations for charging a battery in a power receiving device, according to an embodiment.
FIG. 9 is a flowchart for explaining operations of a processor for supporting wireless charging in a power receiving device, according to an embodiment.
FIG. 10 is a flowchart for explaining operations of a processor for supporting wireless charging in a power receiving device, according to an embodiment.
FIG. 11 is a flowchart for explaining operations for charging a battery in a power receiving device, according to an embodiment.

Hereinafter, embodiments of the present disclosure will be described in detail with reference to the accompanying drawings so that those with ordinary skill in the art to which the present disclosure pertains may easily carry out the embodiments. However, the present disclosure may be implemented in various different ways and is not limited to the embodiments described herein. In connection with the description of the drawings, the similar or same reference numerals may be used for the similar or same constituent elements. In addition, in the drawings and related descriptions, the description of well-known features and configurations may be omitted for clarity and conciseness.

### [Mode for the Invention]

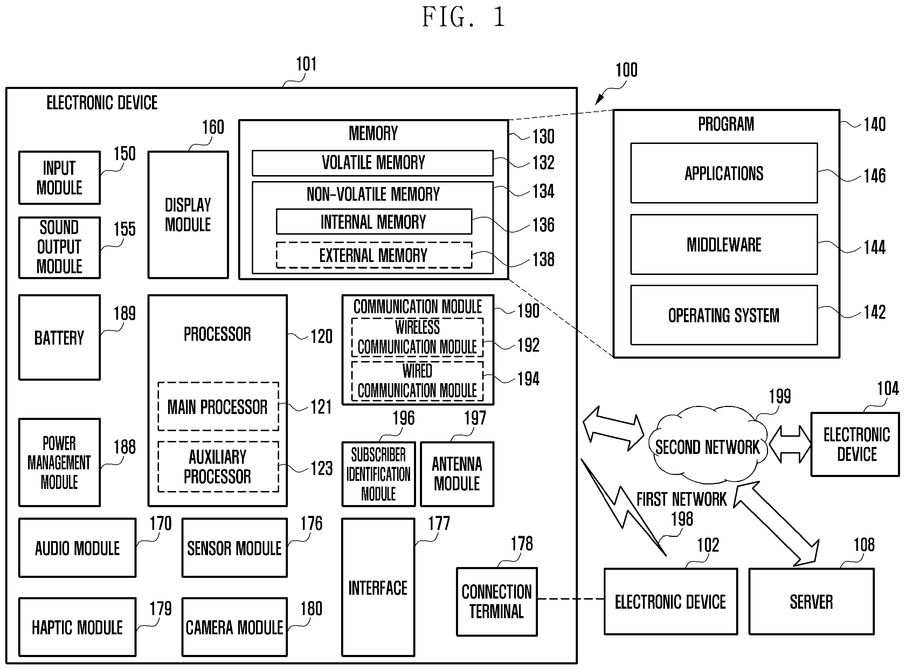

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

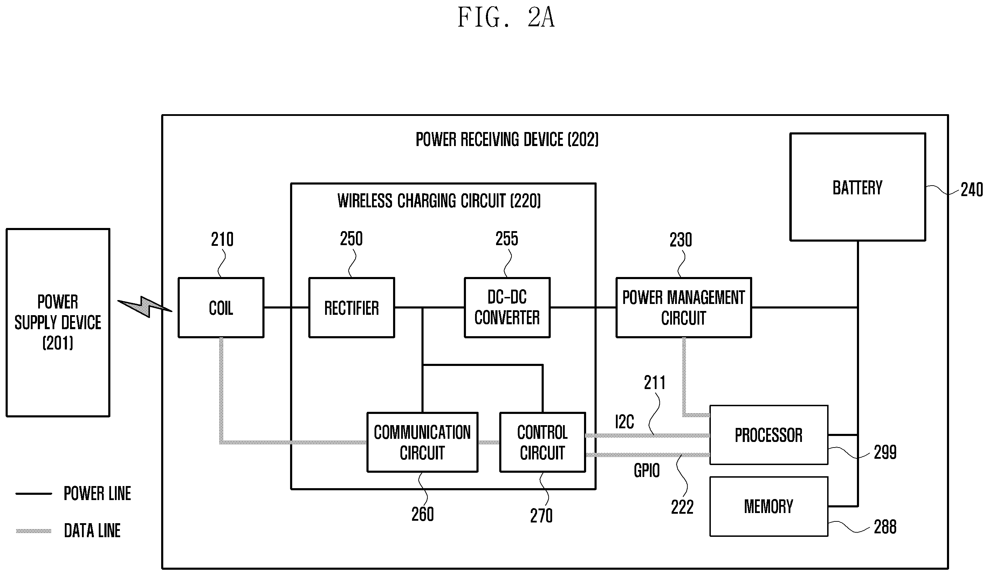

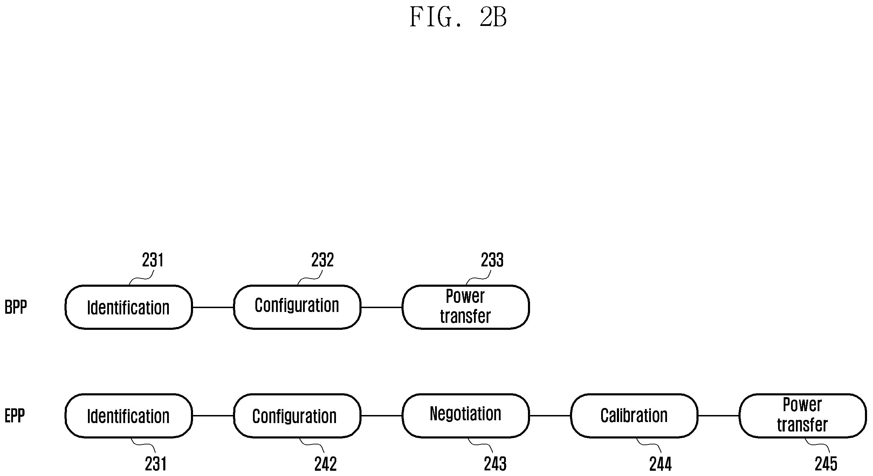

FIG. 2A illustrates a wireless charging system, according to an embodiment. FIG. 2B illustrates a charging profile capable of being implemented in the wireless charging system of FIG. 2A.

With reference to FIG. 2A, a power supply device 201 (e.g., the electronic device 102 of FIG. 1) may wirelessly transmit power. A power receiving device 202 (e.g., the electronic device 101 of FIG. 1) may wirelessly receive power. The wireless charging system may perform wireless charging on the basis of a designated charging protocol. With reference to FIG. 2B, the wireless charging system may perform general wireless charging (in other words, low-speed wireless charging) using a BPP. According to the BPP, the power supply device 201 may perform an operation 231 of identifying the power receiving device 202. For example, the power supply device 201 may identify the power receiving device 202 on the basis of a response of the power receiving device 202 to a ping signal (or, a wakeup signal) transmitted by the power supply device 201. The power supply device 201 may perform an operation 232 of configuring a power value (e.g., 5W) to be transmitted to the identified power receiving device 202 through data communication with the power receiving device 202. The power supply device 201 may perform an operation 233 of transferring power having the configured power value to the power receiving device 202 through a coil. According to an EPP, the power supply device 201 may perform an identification operation 231. The power supply device 201 may perform a configuration operation 242 of a power value (e.g., 15W) to be transmitted to the identified power receiving device 202 through data communication with the power receiving device 202. For example, on the basis of the power supply device 201 being capable of supplying power of 15W or more to the power receiving device 202, an EPP configuration operation 242 for high-speed wireless charging may be performed. After the EPP configuration operation 242 is performed, the power supply device 201 may check a quality of electrical coupling between a transmission coil and a reception coil and perform a negotiation operation 243 of a maximum power capable of being supplied to the power receiving device 202 with the power receiving device 202. After the negotiation operation 243 is completed, the power supply device 201 may perform an operation 244 of measuring power loss (e.g., friendly metal loss), and calibrating a power value to be supplied to the power receiving device 202 on the basis of the measured power loss. The power supply device 201 may perform an operation 245 of transferring power having the calibrated power value to the power receiving device 202 through the coil. The wireless charging system may switch a charging mode from the EPP to the BPP so that disconnection and reconnection are not repeated, when a connection between two devices 201 and 202 is disconnected before a power transfer operation 245 for high-speed wireless charging is performed.

According to an embodiment, the power receiving device 202 may include a coil 210, a wireless charging circuit 220, a power management circuit 230, a battery 240, a memory 288, and a processor 299. The wireless charging circuit 220 (e.g., a circuit configured in a power management module 188 of FIG. 1) may be awakened by a power signal (e.g., digital ping) received from the power supply device 201 through the coil 210. The wireless charging circuit 220 may be configured to perform a given function (e.g., charging of the battery 240 and power delivery (PD) communication with the power supply device 201 therefor) by using power supplied from the power supply device 201. According to an embodiment, a wireless charging circuit 200 may include a rectifier 250 (e.g., an AC-DC converter), a DC-DC converter 255, a communication circuit 260, and a control circuit 270. According to an embodiment, the rectifier 250, the DC-DC converter 255, the communication circuit 260, and the control circuit 270 may be configured as one integrated circuit (IC). For example, it may be included in a magnetic field connectivity (MFC) IC, a wireless charging IC, or a receive (Rx) IC. For example, one IC may be configured to perform operations for rectification, DC-DC converting, communication, and control of the wireless charging circuit 200. According to an embodiment, the control circuit 270 may be configured in an IC separate from at least one of the communication circuit 260, the rectifier 250, and the DC-DC converter 255. According to an embodiment, at least one among the rectifier 250, the DC-DC converter 255, the communication circuit 260, and the control circuit 270 may be configured in one IC (e.g., an interface-integrated (IF) PMIC) together with the power management circuit 230. The memory 288 (e.g., a memory 130 of FIG. 1) and the processor 299 (e.g., a processor 120 of FIG. 1) are a load circuit (in other words, a system) driven by using power supplied from the wireless charging circuit 220 through the power management circuit 230 and/or power supplied from the battery 240. In addition, the load circuit may include a display (e.g., a display module 160 of FIG. 1), and/or a communication circuit (e.g., a communication module 190 of FIG. 1).

The coil 210 may be a spiral type coil wound several times in a clockwise or counterclockwise direction. When the power receiving device 202 is mounted on a charging pad of the power supply device 201, the coil 210 may be aligned side by side with a coil of the power supply device 201. The power receiving device 202 may be supplied with power from the power supply device 201 through electrical coupling between a transmission coil (e.g., a coil of the power supply device 201) and a reception coil (e.g., the coil 210). The coil 210 may resonate at the same frequency as a frequency at which the coil of the power supply device 201 resonates. The power receiving device 202 may further include a resonance circuit for causing the coil 210 to resonate at a specific frequency (e.g., a frequency prescribed in a wireless power consortium (WPC) standard). The coil 210 may be used as an antenna for data communication (e.g., in-band communication) in addition to power reception.

The rectifier 250 may be configured to rectify power received from the power supply device 201 through the coil 210 (i.e., convert current from alternating current (AC) to direct current (DC)) and output the same to the DC-DC converter 255. The DC-DC converter 255 (e.g., low dropout (LDO)) may convert a voltage value (in other words, a voltage level) of power rectified by the rectifier 250 and received from the rectifier 250 into a designated voltage value, and output the same to the power management circuit 230. The power management circuit 230 (e.g., a circuit configured in the power management module 188 of FIG. 1) may adjust a voltage value and/or a current value (in other words, a current level) of power received from the wireless charging circuit 220 and supply the same to the battery 240 and the load circuit. For example, the power management circuit 230 may include a buck converter configured to step down a voltage of power supplied from the wireless charging circuit 220 and output the same, and/or a boost converter configured to step up a voltage of the received power and output the same.

The communication circuit 260 may be configured to perform data communication (e.g., in-band communication) with the power supply device 201 through the coil 210 by using power supplied from the power supply device 201 through the rectifier 250. For example, the communication circuit 260 may receive data from the control circuit 270, and carry the received data on a power signal received from the power supply device 201 to transmit the same to the power supply device 201. As a method for carrying data on a power signal, a technique for modulating an amplitude and/or a frequency of a power signal may be used. For example, the communication circuit 260 may change an amplitude of a power signal by performing switching control to open and close a switch located on an electrical path connecting the coil 210 and a ground of the power receiving device 202. The communication circuit 260 may demodulate a power signal delivered from the power supply device 201 to the coil 210 to acquire data transmitted from the power supply device 201 to the power receiving device 202. The communication circuit 260 may deliver the acquired data to the control circuit 270.

The control circuit 270 may be awakened by a power signal (e.g., digital ping) supplied from the power supply device 201 through the rectifier 250. The control circuit 270 may be configured to, by using power supplied from the power supply device 201 through the rectifier 250, perform data communication with the processor 299 through a communication interface equipped in the power receiving device 201, and perform PD communication for charging the battery 240 with the power supply device through the communication circuit 260. For example, the control circuit 270 may acquire information regarding a charging state from the power supply device 201 through the communication circuit 260 and provide the acquired information to the processor 299 through a first communication interface 211 (e.g., inter integrated circuit (I2C)).

According to an embodiment, on the basis of a signal received from the processor 299 (e.g., a microcontroller unit (MCU) or an application processor (AP)) through a second communication interface 222 (e.g., general-purpose input/output (GPIO)), the control circuit 270 may configure a charging mode of the wireless charging circuit 220 into a first charging mode (e.g., EPP mode) for charging the battery 240 at high speed or a second charging mode (e.g., BPP mode) for charging at relatively low speed compared to the first charging mode.

According to an embodiment, on the basis of being awakened by a wakeup signal received from the power supply device 201 through the coil 210, the control circuit 270 may check a signal received from the processor 299 through the second communication interface 222. On the basis of a first signal having a first voltage level being received from the processor 299 through the second communication interface 222, the control circuit 270 may configure the wireless charging circuit 220 into the first charging mode. For example, the control circuit 270 may sequentially perform an identification operation 231, an EPP configuration operation 242, a negotiation operation 243, a calibration operation 244, and a power transfer operation 245 to charge the battery 240 at high speed. On the basis of a second signal having a second voltage level different from (e.g., lower than) the first voltage level being received from the processor 299 through the second communication interface 222, the control circuit 270 may configure the wireless charging circuit 220 into the second charging mode. For example, the control circuit 270 may sequentially perform an identification operation 231, a BPP configuration operation 232, and a power transfer operation 233 to charge the battery 240 at low speed.

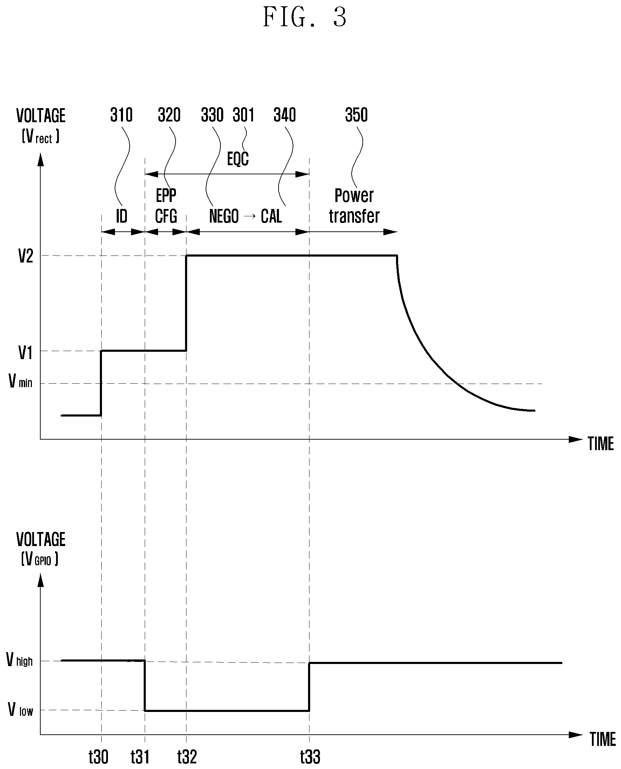

FIG. 3 is a view for explaining operations for wireless charging performed in the control circuit 270 and the processor 299 when a transmission coil and a reception coil are in an aligned state (e.g., when a distance between a center point of the transmission coil and a center point of the reception coil is within a threshold guaranteeing performance of an EPP mode), according to an embodiment.

At a time point t30, a power signal (e.g., a wakeup signal) is received by the power receiving device 202 through the coil 210, and the power signal may be rectified by the rectifier 250 and output to the control circuit 270. The control circuit 270 may be awakened by power rectified by the rectifier 250. For example, a rectified voltage (Vrect) may be V1 higher than a minimum voltage Vmin (e.g., under voltage lock out (UVLO) voltage) for awakening the control circuit 270, and accordingly the control circuit 270 may be awakened. When awakened by the rectified power, the control circuit 270 may perform an identification (indicated as "ID" in FIG. 3) operation 310 (e.g., the identification operation 231 of FIG. 2B) for wireless charging. First, the control circuit 270 may control the communication circuit 260 to transmit an SS ID packet (e.g., a response packet to a digital ping transmitted by the power supply device 201) to the power supply device 201 through the coil 210. Meanwhile, according to various embodiments of the present disclosure, a voltage value VGPIO of the second communication interface 222 is configured to a voltage level corresponding to the first charging mode as a default value. For example, as illustrated, the default value may be a high level (Vhigh). The control circuit 270 may check a voltage level of VGPIO. For example, when awakened by the rectified power, the control circuit 270 may immediately check the voltage level of VGPIO. As another example, on the basis of transmission of the SS ID packet being completed, the control circuit 270 may check the voltage level of VGPIO. On the basis of the voltage level of VGPIO being the high level (Vhigh), the control circuit 270 may perform a configuration (indicated as "EPP CFG" in FIG. 3) operation 320 (e.g., the configuration operation 242 of FIG. 2B) for the EPP. For example, the control circuit 270 may control the communication circuit 260 to transmit a packet for EPP configuration to the power supply device 201. For example, when a 'Neg' bit is configured to 1 in a packet, the power supply device 201 may recognize that the corresponding packet is an EPP configuration packet. The control circuit 270 may transmit a notification message indicating that the EPP configuration packet has been transmitted to the processor 299 through the first communication interface 211. On the basis of the notification message being received, at a time point t31, the processor 299 may change the voltage level of VGPIO to a low level (Vlow) corresponding to the second charging mode.

On the basis of the EPP configuration packet being transmitted to the power supply device 201, at a time point t32, the rectified voltage (Vrect) may rise from V1 to V2. Thereafter, the control circuit 270 may perform a negotiation (indicated as "NEGO" in FIG. 3) operation 330 (e.g., the negotiation operation 243 of FIG. 2B) through PD communication with the power supply device 201. When negotiation is completed, the control circuit 270 may perform a calibration (indicated as "CAL" in FIG. 3) operation 340 (e.g., the calibration operation 244 of FIG. 2B) through PD communication with the power supply device 201. The control circuit 270 may transmit a notification message indicating that calibration is completed to the processor 299 through the first communication interface 211. On the basis of calibration being completed, the control circuit 270 may perform a power transfer operation 350. On the basis of the notification message being received, at a time point t33, the processor 299 may change the voltage level of VGPIO to the high level (Vhigh) (or, a first level) corresponding to the first charging mode.

According to an embodiment, while the negotiation operation 330 or the calibration operation 340 is being performed, the voltage level of VGPIO may be changed from the high level (Vhigh) to the low level (Vlow) (or, a second level). For example, the control circuit 270 may transmit a notification message indicating that the negotiation operation 330 or the calibration operation 340 is being performed to the processor 299 through the first communication interface 211. On the basis of the notification message being received, at a time point t32, the processor 299 may change the voltage level of VGPIO to the low level (Vlow) corresponding to the second charging mode.

According to an embodiment, the configuration operation 320, the negotiation operation 330, and the calibration operation 340 may be collectively referred to as an EPP quality check (EQC) operation 301. After the EPP configuration packet is transmitted to the power supply device 201, the control circuit 270 may perform the EQC operation 301. The control circuit 270 may transmit a notification message indicating that the EQC operation 301 is being performed to the processor 299 through the first communication interface 211. On the basis of the notification message being received, the processor 299 may change the voltage level of VGPIO to the low level (Vlow) corresponding to the second charging mode.

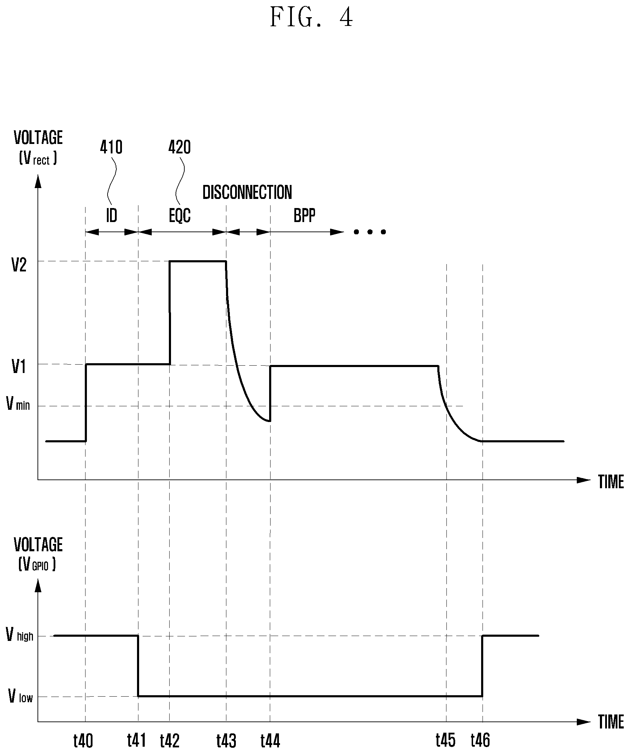

FIG. 4 is a view for explaining operations for wireless charging performed in the control circuit 270 and the processor 299 when a transmission coil and a reception coil are not in an aligned state (when a distance between a center point of the transmission coil and a center point of the reception coil exceeds a threshold guaranteeing performance of an EPP mode), according to an embodiment. Contents overlapping with FIG. 3 are briefly described or omitted.

At a time point t40, the control circuit 270 may be awakened by the rectified voltage (Vrect) becoming V1 exceeding the minimum voltage (Vmin). When awakened by the rectified power, the control circuit 270 may perform an identification (ID) operation 410 (e.g., the identification (ID) operation 310 of FIG. 3). For example, the control circuit 270 may control the communication circuit 260 to transmit an SS ID packet to the power supply device 201 through the coil 210. When awakened by the rectified power or on the basis of the SS ID packet being transmitted, the control circuit 270 may check the voltage level of VGPIO. On the basis of the voltage level of VGPIO being the high level (Vhigh), the control circuit 270 may perform an EQC operation 420 (e.g., the EQC operation 301 of FIG. 3) for high-speed charging. For example, the control circuit 270 may sequentially perform a configuration operation, a negotiation operation, and a calibration operation. The control circuit 270 may transmit a notification message indicating that the EQC operation 420 is being performed to the processor 299 through the first communication interface 211 at a time point t41 (e.g., a time point when an EPP configuration packet is transmitted). On the basis of the notification message being received, the processor 299 may change the voltage level of VGPIO to the low level (Vlow) corresponding to the second charging mode.

On the basis of the EPP configuration packet being transmitted to the power supply device 201, at a time point t42, the rectified voltage (Vrect) may rise from V1 to V2. Thereafter, the control circuit 270 may perform a negotiation operation and subsequently a calibration operation through PD communication with the power supply device 201 using the communication circuit 260. While the negotiation operation or the calibration operation is being performed, a connection between the power supply device 201 and the power receiving device 202 may be disconnected. For example, by the power supply device 201 stopping power transmission at a time point t43, the rectified voltage (Vrect) becomes lower than the minimum voltage (Vmin), and accordingly the control circuit 270 may be deactivated. For example, when an FOD parameter (e.g., Q-factor or Reference Frequency) measured by the power supply device 201 is different from a value received from the power receiving device 202, the power supply device 201 may stop power transmission. As another example, when performing a negotiation stage, when a packet to be received from the power receiving device 202 is frequently omitted due to a poor channel environment, the power supply device 201 may stop power transmission. As another example, when performing a calibration stage, a power value supplied to the power receiving device 202 from the power supply device 201 may fail to converge to a designated target power due to misalignment. Accordingly, the power receiving device 202 may continuously transmit a control error packet (CEP) including a value other than '0' to the power supply device 201 as a request to increase a power value. The power supply device 201 may stop power transmission when the CEP received from the power receiving device 202 does not converge to 0.

After the control circuit 270 is deactivated, at a time point t44, the control circuit 270 may be awakened again by the rectified voltage (Vrect) exceeding the minimum voltage (Vmin). After being awakened, the control circuit 270 may switch a charging mode to the second charging mode. For example, the control circuit 270 may control the communication circuit 260 to transmit an SS ID packet to the power supply device 201 through the coil 210. The control circuit 270 may check the voltage level of VGPIO based at least on being awakened by the rectified power. On the basis of the voltage level of VGPIO being the low level (Vlow), the control circuit 270 may control the communication circuit 260 to transmit a packet for BPP configuration to the power supply device 201. For example, when a 'Neg' bit is configured to 0 in a packet, the power supply device 201 may recognize that the corresponding packet is a BPP configuration packet.

On the basis of the BPP configuration packet being transmitted to the power supply device 201, the rectified voltage (Vrect) is maintained at V1, and power transfer may be performed from the power supply device 201 to the battery 240 through the wireless charging circuit 220. Thereafter, charging may be stopped at a time point t45. For example, when a user separates the power receiving device 202 from the charging pad of the power supply device 201, the power supply device 201 stops power transmission and the rectified voltage (Vrect) becomes lower than the minimum voltage (Vmin), and accordingly the control circuit 270 may be deactivated. The processor 299 may recognize that charging is stopped through the power management circuit 230. As another example, as the battery 240 is 100% charged, the processor 299 may request a stop of power transmission to the power supply device 201 through the control circuit 270, whereby charging may be stopped. At a time point t46 when a predetermined time (e.g., about 1 second) has elapsed from the time point t45 when charging is stopped, the processor 299 may change the voltage level of VGPIO to the high level (Vhigh) corresponding to the first charging mode. Accordingly, when the wireless charging circuit 220 is subsequently awakened by a power signal received from the outside, the wireless charging circuit 220 may initiate charging in the first charging mode.

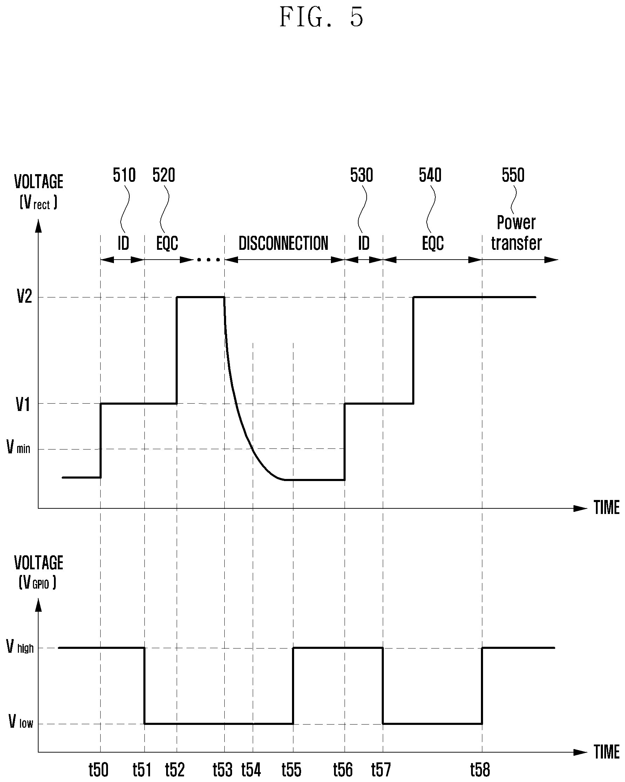

FIG. 5 is a view for explaining operations for wireless charging performed in the control circuit 270 and the processor 299 when a transmission coil and a reception coil are aligned again after separation according to a user's intention, according to an embodiment. Contents overlapping with FIGS. 3 and 4 are briefly described or omitted.

At a time point t50, the control circuit 270 may be awakened by the rectified voltage (Vrect) becoming V1 exceeding the minimum voltage (Vmin). When awakened by the rectified power, the control circuit 270 may perform an identification (ID) operation 510. For example, the control circuit 270 may control the communication circuit 260 to transmit an SS ID packet to the power supply device 201 through the coil 210. When awakened by the rectified power or on the basis of the SS ID packet being transmitted, the control circuit 270 may check the voltage level of VGPIO. On the basis of the voltage level of VGPIO being the high level (Vhigh), the control circuit 270 may perform an EQC operation 520 for high-speed charging. For example, the control circuit 270 may sequentially perform a configuration operation, a negotiation operation, and a calibration operation. The control circuit 270 may transmit a notification message indicating that the EQC operation 520 is being performed to the processor 299 through the first communication interface 211 at a time point t51 (e.g., a time point when an EPP configuration packet is transmitted). On the basis of the notification message being received, the processor 299 may change the voltage level of VGPIO to the low level (Vlow) corresponding to the second charging mode.

On the basis of the EPP configuration packet being transmitted to the power supply device 201, at a time point t52, the rectified voltage (Vrect) may rise from V1 to V2. Thereafter, the control circuit 270 may perform a negotiation operation and subsequently a calibration operation through PD communication with the power supply device 201 using the communication circuit 260. While the EQC operation 520 (e.g., a negotiation operation or a calibration operation) is being performed, due to separation according to a user's intention (i.e., release of electrical coupling between the transmission and reception coils), at a time point t53, a connection between the devices 201 and 202 may be disconnected. The processor 299 may recognize that the connection is disconnected through the power management circuit 230 at a time point t54. At a time point t55 when a predetermined time (e.g., about 1 second) has elapsed from the time point t54 when charging is stopped, the processor 299 may change the voltage level of VGPIO to the high level (Vhigh) corresponding to the first charging mode.

Due to alignment between the transmission and reception coils according to a user's intention (e.g., re-performing charging), at a time point t56, the control circuit 270 may be awakened by the rectified voltage (Vrect) becoming V1 exceeding the minimum voltage (Vmin). When awakened by the rectified power, the control circuit 270 may perform an identification (ID) operation 530. For example, the control circuit 270 may control the communication circuit 260 to transmit an SS ID packet to the power supply device 201 through the coil 210. When awakened by the rectified power or on the basis of the SS ID packet being transmitted, the control circuit 270 may check the voltage level of VGPIO. On the basis of the voltage level of VGPIO being the high level (Vhigh), the control circuit 270 may perform an EQC operation 540 for high-speed charging. The control circuit 270 may transmit a notification message indicating that the EQC operation 540 is being performed to the processor 299 through the first communication interface 211 at a time point t57 (e.g., a time point when an EPP configuration packet is transmitted). On the basis of the notification message being received, the processor 299 may change the voltage level of VGPIO to the low level (Vlow) corresponding to the second charging mode.

On the basis of the EPP configuration packet being transmitted to the power supply device 201, the rectified voltage (Vrect) may rise from V1 to V2. Thereafter, the control circuit 270 may complete a negotiation operation and subsequently a calibration operation through PD communication with the power supply device 201 and perform a power transfer operation 550. The control circuit 270 may transmit a notification message indicating that calibration is completed to the processor 299 through the first communication interface 211. On the basis of the notification message being received, at a time point t58, the processor 299 may change the voltage level of VGPIO to the high level (Vhigh) corresponding to the first charging mode.

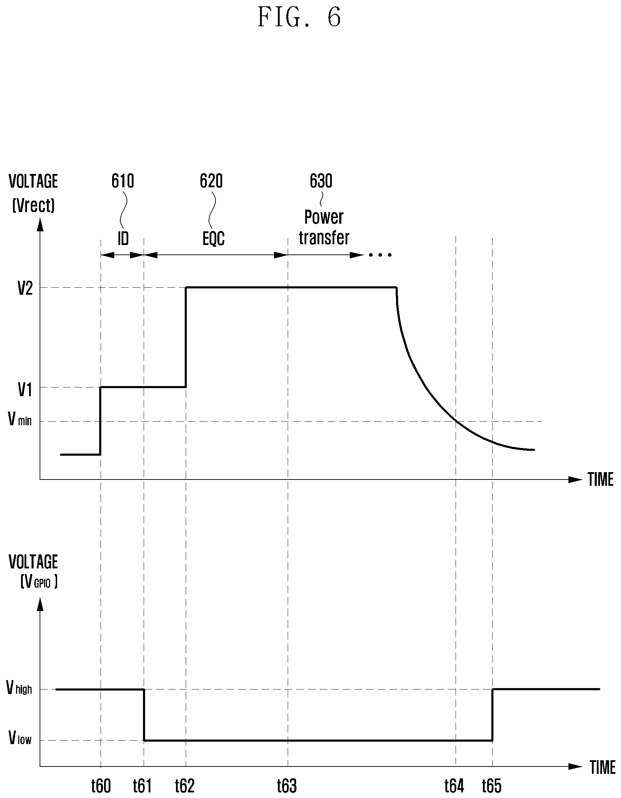

FIG. 6 is a view for explaining operations for wireless charging performed in the control circuit 270 and the processor 299 when a transmission coil and a reception coil are in an aligned state, according to an embodiment. Contents overlapping with FIG. 3 are briefly described or omitted.

At a time point t60, the control circuit 270 may be awakened by the rectified voltage (Vrect) becoming V1 exceeding the minimum voltage (Vmin). When awakened by the rectified power, an identification (ID) operation 610 may be performed. For example, the control circuit 270 may control the communication circuit 260 to transmit an SS ID packet to the power supply device 201 through the coil 210. When awakened by the rectified power or on the basis of the SS ID packet being transmitted, the control circuit 270 may check the voltage level of VGPIO. On the basis of the voltage level of VGPIO being the high level (Vhigh), the control circuit 270 may perform an EQC operation 620 for high-speed charging. The control circuit 270 may transmit a notification message indicating that the EQC operation 620 is being performed to the processor 299 through the first communication interface 211 at a time point t61 (e.g., a time point when an EPP configuration packet is transmitted). On the basis of the notification message being received, the processor 299 may change the voltage level of VGPIO to the low level (Vlow) corresponding to the second charging mode.

On the basis of the EPP configuration packet being transmitted to the power supply device 201, the rectified voltage (Vrect) may rise from V1 to V2. Thereafter, the control circuit 270 may perform a negotiation operation and subsequently a calibration operation through PD communication with the power supply device 201 through the communication circuit 260. Thereafter, at a time point t63 when calibration is completed, the control circuit 270 may perform a power transfer operation 630 from the power supply device 201 to the battery 240 through the wireless charging circuit 220.

Thereafter, charging may be stopped at a time point t64. For example, when a user separates the power receiving device 202 from the charging pad of the power supply device 201, the power supply device 201 stops power transmission, whereby the rectified voltage (Vrect) becomes lower than the minimum voltage (Vmin), and accordingly the control circuit 270 may be deactivated. The processor 299 may recognize that charging is stopped through the power management circuit 230. As another example, as the battery 240 is 100% charged, the processor 299 may request a stop of power transmission to the power supply device 201 through the control circuit 270, whereby charging may be stopped. At a time point t65 when a predetermined time (e.g., about 1 second) has elapsed from the time point t64 when charging is stopped, the processor 299 may change the voltage level of VGPIO to the high level (Vhigh) corresponding to the first charging mode.

According to an embodiment, an internal source (e.g., the battery 240 or the power management circuit 230) supplying power may be connected to the control circuit 270. Accordingly, even if a rectified voltage becomes equal to or less than a minimum value, the wireless charging circuit 220 may be prevented from being reset. For example, when a phenomenon in which a rectified voltage decreases to equal to or less than a minimum value (Vmin) due to an un-smooth alignment state between the transmission coil and the reception coil is repeated several times (e.g., twice), the wireless charging circuit 220 may change a charging mode from the first charging mode (e.g., EPP mode) to the second charging mode (e.g., BPP mode) to charge the battery 240 at low speed.

According to an embodiment, the control circuit 270 may record a progress process of a charging mode in a non-volatile memory (e.g., a non-volatile memory 134 of FIG. 1), and on the basis of information regarding the recorded progress process, change a charging mode from the EPP mode to the BPP mode to charge the battery 240 at low speed. For example, the control circuit 270 may record information indicating that an EPP configuration packet is transmitted in a memory. After such information is recorded, the control circuit 270 is awakened again, and may check from the information recorded in the memory that a negotiation operation has not proceeded as a next stage after the EPP configuration packet was transmitted. Accordingly, the wireless charging circuit 220 may change a charging mode from the EPP mode to the BPP mode to charge the battery 240 at low speed.

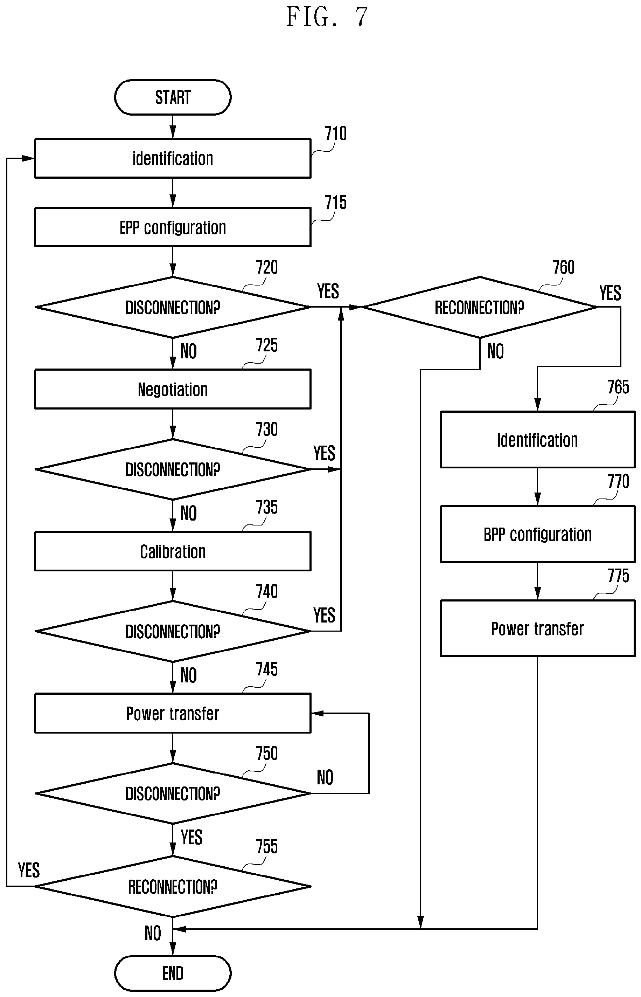

FIG. 7 is a flowchart for explaining operations for charging a battery (e.g., a battery 189 of FIG. 1 or the battery 240 of FIG. 2A) in a power receiving device (e.g., the electronic device 101 of FIG. 1 or the power receiving device 202 of FIG. 2A), according to an embodiment. Operations of FIG. 7 may be performed, when a wireless charging circuit (e.g., a charging circuit configured in the power management module 188 of FIG. 1 or the wireless charging circuit 220 of FIG. 2A) is awakened by a power signal (e.g., digital ping) received from a power supply device (e.g., the electronic device 102 of FIG. 1 or the power supply device 201 of FIG. 2A) through a coil (e.g., the coil 210 of FIG. 2A).

In operation 710, the power receiving device may transmit a packet for identification (e.g., SS ID packet) to the power supply device. In operation 715, the power receiving device may transmit a packet for EPP configuration to the power supply device.

After the SS ID packet and the EPP configuration packet are transmitted, in operation 720, the power receiving device may determine whether a connection for wireless charging with the power supply device is disconnected. For example, the power receiving device checks a voltage value of power rectified and output from a rectifier (e.g., the rectifier 250 of FIG. 2A), and may determine that a connection between devices is disconnected when a rectified voltage is smaller than a minimum value (e.g., UVLO voltage).

When it is determined in operation 720 that a connection is being maintained, in operation 725, the power receiving device may perform negotiation according to the EPP through data communication with the power supply device. In operation 730, the power receiving device may determine whether a connection with the power supply device is disconnected before negotiation is completed.

When negotiation is completed and it is determined in operation 730 that a connection is being maintained, in operation 735, the power receiving device may perform calibration according to the EPP through data communication with the power supply device. In operation 740, the power receiving device may determine whether a connection with the power supply device is disconnected before calibration is completed.

When calibration is completed and it is determined in operation 740 that a connection is being maintained, in operation 745, the power supply device may perform power transfer. That is, in operation 745, the power receiving device may perform an operation of high-speed charging the battery by using power supplied from the power supply device. In operation 750, the power receiving device may determine whether a connection with the power supply device is disconnected during high-speed charging of the battery. When it is determined in operation 750 that a connection is being maintained, the power receiving device may continuously perform the high-speed charging operation 745.

When it is determined in operation 750 that a connection is disconnected, in operation 755, the power receiving device may determine whether reconnection with the power supply device is made. For example, the power receiving device checks a voltage value of power rectified and output from the rectifier, and may determine that reconnection between devices is made when a rectified voltage is equal to or greater than a minimum value (e.g., UVLO voltage). When it is determined in operation 755 that reconnection is made, the power receiving device may restart from operation 710 of transmitting a packet for identification for wireless charging.

When it is determined in operation 720, operation 730, or operation 740 that a connection with the power supply device is disconnected, in operation 760, the power receiving device may determine whether reconnection with the power supply device is made.

When it is determined in operation 760 that reconnection is made, in operation 765, the power receiving device may transmit a packet for identification to the power supply device. In operation 770, the power receiving device may transmit a packet for BPP configuration to the power supply device. In operation 775, the power supply device may perform power transfer. That is, in operation 775, the power receiving device may perform an operation of low-speed charging the battery by using power supplied from the power supply device.

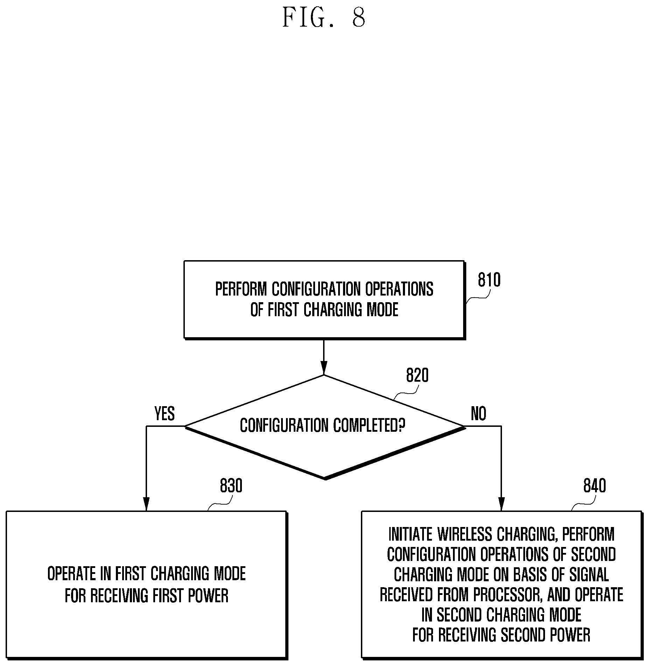

FIG. 8 is a flowchart for explaining operations for charging a battery (e.g., a battery 189 of FIG. 1 or the battery 240 of FIG. 2A) in a power receiving device (e.g., the electronic device 101 of FIG. 1 or the power receiving device 202 of FIG. 2A), according to an embodiment. Operations of FIG. 8 may be performed, when a wireless charging circuit (e.g., a charging circuit configured in the power management module 188 of FIG. 1 or the wireless charging circuit 220 of FIG. 2A) is awakened by a power signal (e.g., digital ping) received from a power supply device (e.g., the electronic device 102 of FIG. 1 or the power supply device 201 of FIG. 2A) through a coil (e.g., the coil 210 of FIG. 2A).

In operation 810, the wireless charging circuit may perform configuration operations of a first charging mode for receiving first power from the power supply device. As an example, a processor (e.g., the processor 299) may be configured to output a signal related to a charging mode of the wireless charging circuit. The wireless charging circuit checks a state of a signal received from the processor through a communication interface (e.g., the second communication interface 222 of FIG. 2A), and may perform configuration operations of the first charging mode when the checked state is a first state. With reference to FIG. 2B, the configuration operations of the first charging mode may include an EPP configuration operation 242, a negotiation operation 243, and a calibration operation 244. According to an embodiment, while the wireless charging circuit performs the configuration operations of the first charging mode, the processor may change a signal output to the wireless charging circuit from a first state indicating the first charging mode to a second state indicating a second charging mode. For example, on the basis of checking through the wireless charging circuit that the EPP configuration operation 242 is initiated, the processor may change a voltage level of VGPIO output to the wireless charging circuit from high (a first state) to low (a second state). As another example, the processor checks through the wireless charging circuit that the negotiation operation 243 or the calibration operation 244 is being performed, and on the basis of such checking, may change a voltage level of VGPIO output to the wireless charging circuit from high (a first state) to low (a second state).

In operation 820, the wireless charging circuit may check whether the configuration operations of the first charging mode are completed.

When the configuration operations of the first charging mode are completed (operation 820-Yes), in operation 830, the wireless charging circuit may operate in the first charging mode for receiving the first power. For example, with reference to FIG. 2B, on the basis of the calibration operation 244 being completed, the wireless charging circuit may perform a power transfer operation 245. According to an embodiment, on the basis of the configuration operations of the first charging mode being completed, the processor may change a signal output to the wireless charging circuit from the second state to the first state. For example, the processor checks through the wireless charging circuit that the power transfer operation 245 is initiated as the configuration operations of the first charging mode are completed, and at a time point when initiation of the power transfer operation 245 is checked (e.g., t33 (see FIG. 3)), may change a voltage level of VGPIO output to the wireless charging circuit from low (a second state) to high (a first state). According to an embodiment, when a user separates the power receiving device from the charging pad of the power supply device or when the battery is 100% charged, the power supply device may stop power transmission. In accordance with a stop of power transmission, the rectified voltage (Vrect) becomes lower than the minimum voltage (Vmin), and accordingly the wireless charging circuit may be deactivated. The processor may recognize that charging is stopped through a power management circuit (e.g., the power management circuit 230 of FIG. 2A). After a designated time has elapsed from a time point when a stop of charging is recognized (e.g., t54 (see FIG. 5) or t64 (see FIG. 6)), the processor may change a signal output to the wireless charging circuit to the first state.

When the configuration operations of the first charging mode fail (operation 820-No), in operation 840, the wireless charging circuit initiates wireless charging (e.g., the wireless charging circuit is awakened by a wakeup signal to perform an identification operation 231; see FIG. 2B), and on the basis of a signal (e.g., a signal of a second state indicating a second charging mode) received from a processor (e.g., the processor 299 of FIG. 2A), performs configuration operations of a second charging mode (e.g., BPP configuration operation 232; see FIG. 2B) for receiving second power lower than the first power from the power supply device, and may operate in the second charging mode for receiving the second power. According to an embodiment, on the basis of the configuration operations of the first charging mode failing, the processor may maintain a state of a signal output to the wireless charging circuit in the second state. On the basis of reception of power being ended in the second charging mode, the processor may change a state of a signal output to the wireless charging circuit from the second state to the first state. For example, when a user separates the power receiving device from the charging pad of the power supply device or when the battery is 100% charged, the power supply device may stop power transmission. In accordance with a stop of power transmission, the rectified voltage (Vrect) becomes lower than the minimum voltage (Vmin), and accordingly the wireless charging circuit may be deactivated. The processor may recognize that charging is stopped through a power management circuit (e.g., the power management circuit 230 of FIG. 2A). After a designated time has elapsed from a time point when a stop of charging is recognized (e.g., t45 (see FIG. 4)), the processor may change a signal output to the wireless charging circuit to the first state.

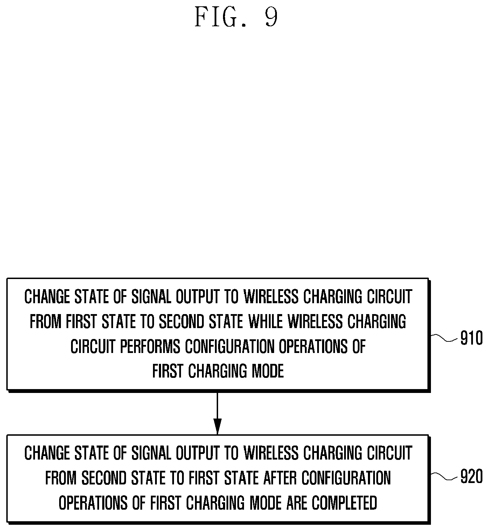

FIG. 9 is a flowchart for explaining operations of a processor (the processor 299 of FIG. 2A) for supporting wireless charging in a power receiving device (e.g., the electronic device 101 of FIG. 1 or the power receiving device 202 of FIG. 2A), according to an embodiment. Contents overlapping with FIG. 8 are briefly described or omitted.

In operation 910, while a wireless charging circuit performs configuration operations of a first charging mode, the processor may change a state of a signal output to the wireless charging circuit from a first state (e.g., high) to a second state (e.g., low). For example, the processor checks through the wireless charging circuit that an EPP configuration operation 242 is initiated, and at a time point when initiation of the EPP configuration operation 242 is checked (e.g., t31 (see FIG. 3)), may change a voltage level of VGPIO output to the wireless charging circuit from the first state to the second state. As another example, the processor checks through the wireless charging circuit that a negotiation operation 243 or a calibration operation 244 is being performed, and on the basis of such checking, may change a voltage level of VGPIO output to the wireless charging circuit from the first state to the second state.

In operation 920, after the configuration operations of the first charging mode are completed, the processor may change a state of a signal output to the wireless charging circuit from the second state to the first state. For example, the processor checks through the wireless charging circuit that a power transfer operation 245 (see FIG. 2B) is initiated as the configuration operations of the first charging mode are completed, and at a time point when initiation of the power transfer operation 245 is checked (e.g., t33 (see FIG. 3)), may change a voltage level of VGPIO output to the wireless charging circuit from the second state to the first state. As another example, when a user separates the power receiving device from the charging pad of the power supply device or when the battery is 100% charged, the power supply device may stop power transmission. In accordance with a stop of power transmission, the rectified voltage (Vrect) becomes lower than the minimum voltage (Vmin), and accordingly the wireless charging circuit may be deactivated. The processor may recognize that charging is stopped through a power management circuit (e.g., the power management circuit 230 of FIG. 2A). After a designated time has elapsed from a time point when a stop of charging is recognized (e.g., t54 (see FIG. 5) or t64 (see FIG. 6)), the processor may change a signal output to the wireless charging circuit to the first state.

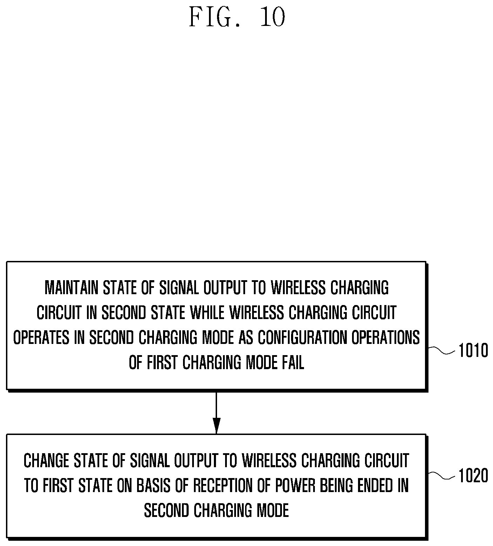

FIG. 10 is a flowchart for explaining operations of a processor (the processor 299 of FIG. 2A) for supporting wireless charging in a power receiving device (e.g., the electronic device 101 of FIG. 1 or the power receiving device 202 of FIG. 2A), according to an embodiment. Contents overlapping with FIG. 8 are briefly described or omitted.

In operation 1010, as the configuration operations of the first charging mode fail, while the wireless charging circuit operates in a second charging mode, the processor may maintain a state of a signal output to the wireless charging circuit in a second state.

In operation 1020, on the basis of reception of power being ended in the second charging mode, the processor may change a state of a signal output to the wireless charging circuit from the second state to a first state. For example, when a user separates the power receiving device from the charging pad of the power supply device or when the battery is 100% charged, the power supply device may stop power transmission. In accordance with a stop of power transmission, the rectified voltage (Vrect) becomes lower than the minimum voltage (Vmin), and accordingly the wireless charging circuit may be deactivated. The processor may recognize that charging is stopped through a power management circuit (e.g., the power management circuit 230 of FIG. 2A). After a designated time has elapsed from a time point when a stop of charging is recognized (e.g., t45 (see FIG. 4)), the processor may change a signal output to the wireless charging circuit to the first state.

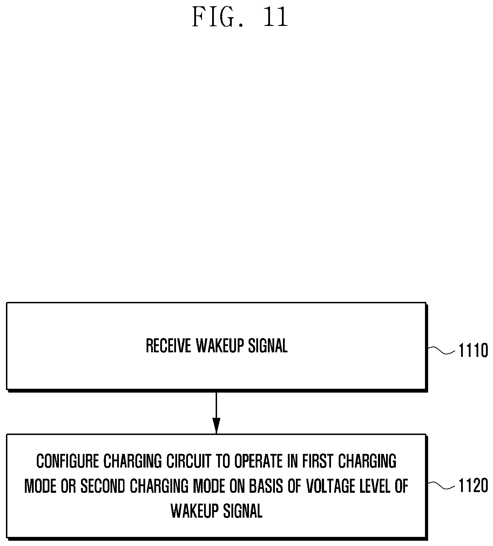

FIG. 11 is a flowchart for explaining operations for charging a battery (e.g., a battery 189 of FIG. 1 or the battery 240 of FIG. 2A) in a power receiving device (e.g., the electronic device 101 of FIG. 1 or the power receiving device 202 of FIG. 2A), according to an embodiment. Operations of FIG. 11 may be performed, when a wireless charging circuit (e.g., a charging circuit configured in the power management module 188 of FIG. 1 or a wireless charging circuit 220 of FIG. 2) is awakened by a power signal (e.g., digital ping) received from a power supply device (e.g., the electronic device 102 of FIG. 1 or the power supply device 201 of FIG. 2A) through a coil (e.g., the coil 210 of FIG. 2A).

In operation 1110, the power receiving device may receive a wakeup signal (e.g., digital ping) for awakening the wireless charging circuit from the power supply device through the coil.

In operation 1120, on the basis of a voltage level of the wakeup signal, the power receiving device may configure the wireless charging circuit to operate in a first charging mode (e.g., EPP mode) for being supplied with first power from the power supply device or a second charging mode (e.g., BPP mode) for being supplied with second power lower than the first power from the power supply device. As an example, when a voltage level of the wakeup signal is higher than a minimum value (e.g., UVLO voltage) and lower than a threshold (e.g., about 2.6V), the power receiving device may configure the wireless charging circuit to operate in the second charging mode. When a voltage level of the wakeup signal is higher than a threshold, the power receiving device may configure the wireless charging circuit to operate in the first charging mode.

According to an embodiment, an electronic device (e.g., the power receiving device 202) may include a battery; a coil; a wireless charging circuit configured to rectify power received from a power supply device through the coil and provide the rectified power to charge the battery; and a processor configured to output a signal related to a charging mode of the wireless charging circuit. The wireless charging circuit may be configured to perform configuration operations of a first charging mode for receiving first power from the power supply device. The wireless charging circuit may be configured to operate in the first charging mode for receiving the first power when the configuration operations of the first charging mode are completed. The wireless charging circuit may be configured to, when the configuration operations of the first charging mode fail, initiate wireless charging, and perform configuration operations of a second charging mode for receiving second power lower than the first power from the power supply device on the basis of a signal received from the processor, and operate in the second charging mode for receiving the second power.

The processor may be configured to, while the wireless charging circuit performs the configuration operations of the first charging mode, change a signal output to the wireless charging circuit from a first state indicating the first charging mode to a second state indicating the second charging mode.

The configuration operations of the first charging mode may include a power value configuration operation for configuring a power value to be supplied from the power supply device to the electronic device, a negotiation operation for negotiating a maximum power value capable of being supplied from the power supply device to the electronic device, and a calibration operation for calibrating a power value to be supplied from the power supply device to the electronic device.

The processor may be configured to, while the power value configuration operation, the negotiation operation, or the calibration operation is being performed, change a signal output to the wireless charging circuit from the first state to the second state.

The processor may be configured to, after the configuration operations of the first charging mode are completed, change a signal output to the wireless charging circuit from the second state to the first state.

When the configuration operations of the first charging mode fail, the processor may be configured to, while power is received in the second charging mode, maintain a signal output to the wireless charging circuit in the second state indicating the second charging mode. The processor may be configured to, after reception of power is ended in the second charging mode, change a signal output to the wireless charging circuit from the second state to the first state indicating the first charging mode.

The processor may be configured to, after a designated time has elapsed since reception of power was ended in the second charging mode, change a signal output to the wireless charging circuit from the second state to the first state.

The processor may be configured to, when a voltage value of power rectified in the wireless charging circuit is equal to or less than a designated minimum value, recognize that charging of the battery is ended.

The processor and the wireless charging circuit may be connected through a designated communication interface. The processor may be configured to, while the wireless charging circuit performs the configuration operations of the first charging mode, change a voltage level of a signal output to the charging circuit through the communication interface from a first level corresponding to the first charging mode to a second level corresponding to the second charging mode. The processor may be configured to, on the basis of the configuration operations of the first charging mode being completed, change a voltage level of a signal output to the charging circuit through the communication interface from the second level to the first level.

The communication interface may include a general-purpose input/output (GPIO) pin.

The configuration operations of the first charging mode may include a calibration operation for calibration of a power value in the wireless charging circuit. The processor may be configured to, on the basis of the calibration operation being completed, change the voltage level from the second level to the first level.

The processor may be configured to, on the basis of charging of the battery being ended after the configuration operations of the first charging mode are completed, change the voltage level from the second level to the first level.

The processor may be configured to, after a designated time has elapsed since charging of the battery was ended, change the voltage level from the second level to the first level.

According to an embodiment, a method for operating an electronic device (e.g., the power receiving device 202) may include an operation of performing, by a wireless charging circuit of the electronic device, configuration operations of a first charging mode for receiving first power from a power supply device through a coil of the electronic device. The method may comprise operating, by the wireless charging circuit, in the first charging mode for receiving the first power when the configuration operations of the first charging mode are completed. The method may comprise, when the configuration operations of the first charging mode fail, initiating wireless charging by the wireless charging circuit, performing configuration operations of a second charging mode for receiving second power lower than the first power from the power supply device on the basis of a signal output from a processor of the electronic device to the wireless charging circuit, and operating in the second charging mode for receiving the second power.

The method may further include an operation of, while the wireless charging circuit performs the configuration operations of the first charging mode, changing, by the processor, a signal output to the wireless charging circuit from a first state indicating the first charging mode to a second state indicating the second charging mode.

The method may further include an operation of, after the configuration operations of the first charging mode are completed, changing, by the processor, a signal output to the wireless charging circuit from the second state to the first state.

The method may further include an operation of, when the configuration operations of the first charging mode fail, while power is received in the second charging mode, maintaining, by the processor, a signal output to the wireless charging circuit in the second state indicating the second charging mode. The method may further include an operation of, after reception of power is ended in the second charging mode, changing, by the processor, a signal output to the wireless charging circuit from the second state to the first state indicating the first charging mode.

The operation of changing from the second state to the first state may include an operation of changing a signal output to the wireless charging circuit from the second state to the first state, after a designated time has elapsed since reception of power was ended in the second charging mode.

The processor and the wireless charging circuit may be connected through a designated communication interface. The method may further include an operation of, while the wireless charging circuit performs the configuration operations of the first charging mode, changing, by the processor, a voltage level of a signal output to the charging circuit through the communication interface from a first level corresponding to the first charging mode to a second level corresponding to the second charging mode. The method may further include an operation of, on the basis of the configuration operations of the first charging mode being completed, changing, by the processor, a voltage level of a signal output to the charging circuit through the communication interface from the second level to the first level.

The configuration operations of the first charging mode may include a calibration operation for calibration of a power value in the wireless charging circuit. The method may further include an operation of, on the basis of the calibration operation being completed, changing, by the processor, the voltage level from the second level to the first level.

The method may further include an operation of, on the basis of charging of the battery being ended after the configuration operations of the first charging mode are completed, changing, by the processor, the voltage level from the second level to the first level.

According to an embodiment, a non-transitory recording medium may store instructions readable by an electronic device (e.g., the power receiving device 202). The instructions, when executed, may cause the electronic device to perform an operation of performing, by a wireless charging circuit of the electronic device, configuration operations of a first charging mode for receiving first power from a power supply device through a coil of the electronic device. The instructions, when executed, may cause the electronic device to perform an operation of operating, by the wireless charging circuit, in the first charging mode for receiving the first power when the configuration operations of the first charging mode are completed. The instructions, when executed, may cause the electronic device to perform an operation of, when the configuration operations of the first charging mode fail, initiating wireless charging by the wireless charging circuit, performing configuration operations of a second charging mode for receiving second power lower than the first power from the power supply device on the basis of a signal output from a processor of the electronic device to the wireless charging circuit, and operating in the second charging mode for receiving the second power.

In the above description, prefixes such as "first," "second," and "third" are only for distinguishing the same names and do not assign special meanings such as importance or order in themselves.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device, comprising:
a battery;
a coil;
a wireless charging circuit configured to rectify power received from a power supply device through the coil and provide the rectified power to charge the battery; and
a processor configured to output a signal related to a charging mode of the wireless charging circuit,
wherein the wireless charging circuit is configured to:
perform configuration operations of a first charging mode for receiving first power from the power supply device;
operate in the first charging mode for receiving the first power when the configuration operations of the first charging mode are completed; and
when the configuration operations of the first charging mode fail, initiate wireless charging, perform configuration operations of a second charging mode for receiving second power lower than the first power from the power supply device on the basis of a signal received from the processor, and operate in the second charging mode for receiving the second power.

2. The electronic device of claim 1, wherein the processor is configured to, while the wireless charging circuit performs the configuration operations of the first charging mode, change a signal output to the wireless charging circuit from a first state indicating the first charging mode to a second state indicating the second charging mode.

3. The electronic device of claim 2, wherein the configuration operations of the first charging mode comprise:
a power value configuration operation for configuring a power value to be supplied from the power supply device to the electronic device;
a negotiation operation for negotiating a maximum power value capable of being supplied from the power supply device to the electronic device; and
a calibration operation for calibrating a power value to be supplied from the power supply device to the electronic device, and
wherein the processor is configured to, while the power value configuration operation, the negotiation operation, or the calibration operation is being performed, change a signal output to the wireless charging circuit from the first state to the second state.

4. The electronic device of claim 2, wherein the processor is configured to, after the configuration operations of the first charging mode are completed, change a signal output to the wireless charging circuit from the second state to the first state.

5. The electronic device of claim 1, wherein, when the configuration operations of the first charging mode fail, the processor is configured to, while power is received in the second charging mode, maintain a signal output to the wireless charging circuit in a second state indicating the second charging mode, and after reception of power is ended in the second charging mode, change a signal output to the wireless charging circuit from the second state to a first state indicating the first charging mode.

6. The electronic device of claim 5, wherein the processor is configured to, after a designated time has elapsed since reception of power was ended in the second charging mode, change a signal output to the wireless charging circuit from the second state to the first state.

7. The electronic device of claim 6, wherein the processor is configured to, when a voltage value of power rectified in the wireless charging circuit is equal to or less than a designated minimum value, recognize that charging of the battery is ended.

8. The electronic device of claim 1, wherein the processor and the wireless charging circuit are connected through a designated communication interface, and
wherein the processor is configured to, while the wireless charging circuit performs the configuration operations of the first charging mode, change a voltage level of a signal output to the charging circuit through the communication interface from a first level corresponding to the first charging mode to a second level corresponding to the second charging mode, and on the basis of the configuration operations of the first charging mode being completed, change a voltage level of a signal output to the charging circuit through the communication interface from the second level to the first level.

9. The electronic device of claim 8, wherein the communication interface comprises a general-purpose input/output (GPIO) pin.

10. The electronic device of claim 8, wherein the configuration operations of the first charging mode comprise a calibration operation for calibration of a power value in the wireless charging circuit, and
wherein the processor is configured to, on the basis of the calibration operation being completed, change the voltage level from the second level to the first level.

11. The electronic device of claim 8, wherein the processor is configured to, on the basis of charging of the battery being ended after the configuration operations of the first charging mode are completed, change the voltage level from the second level to the first level.

12. The electronic device of claim 11, wherein the processor is configured to, after a designated time has elapsed since charging of the battery was ended, change the voltage level from the second level to the first level.

13. A method for operating an electronic device, comprising:
performing, by a wireless charging circuit of the electronic device, configuration operations of a first charging mode for receiving first power from a power supply device through a coil of the electronic device;
operating, by the wireless charging circuit, in the first charging mode for receiving the first power when the configuration operations of the first charging mode are completed; and
when the configuration operations of the first charging mode fail, initiating wireless charging by the wireless charging circuit, performing configuration operations of a second charging mode for receiving second power lower than the first power from the power supply device on the basis of a signal output from a processor of the electronic device to the wireless charging circuit, and operating in the second charging mode for receiving the second power.

14. The method of claim 13, further comprising:
while the wireless charging circuit performs the configuration operations of the first charging mode, changing, by the processor, a signal output to the wireless charging circuit from a first state indicating the first charging mode to a second state indicating the second charging mode.

15. The method of claim 13, further comprising:
when the configuration operations of the first charging mode fail, maintaining, by the processor, a signal output to the wireless charging circuit in a second state indicating the second charging mode while power is received in the second charging mode; and
after reception of power is ended in the second charging mode, changing, by the processor, a signal output to the wireless charging circuit from the second state to a first state indicating the first charging mode.
